# FASCICULE DE BREVET EUROPEEN

(11) **EP 3 428 908 B1**
(45) Date de publication et mention de la délivrance du brevet: **17.11.2021**
(21) Numéro de dépôt: 18182512.6
(22) Date de dépôt: 09.07.2018
(51) Int. Cl.: G09G 3/32

(54) **AFFICHEUR TRANSPARENT A MATRICE ACTIVE COMPORTANT DES PIXELS EMISSIFS A DIODES ELECTROLUMINESCENTES COLOREES**
TRANSPARENTE ANZEIGEVORRICHTUNG MIT AKTIVEN MATRIX VON LED FARBPIXELN
TRANSPARENT ACTIVE MATRIX DISPLAY COMPRISING COLORED LED PIXELS

(30) Priorité: 13.07.2017 FR 1700754
(43) Date de publication de la demande: 16.01.2019
(73) Titulaire: THALES, 92400 Courbevoie (FR)
(72) Inventeur: LEBRUN, Hugues, 38500 COUBLEVIE (FR)
(74) Mandataire: Marks & Clerk France

(56) Documents cités:
- US-A1- 2006 001 625
- US-A1- 2008 218 465
- US-A1- 2009 283 781
- US-A1- 2012 168 789
- US-A1- 2012 223 875
- US-A1- 2014 353 694
- US-A1- 2015 371 585

## Description

Le domaine de l'invention est celui des dispositifs de visualisation transparents qui permettent d'afficher une image ou des informations en superposition sur l'extérieur. On peut notamment les utiliser dans le domaine automobile ou en aéronautique.

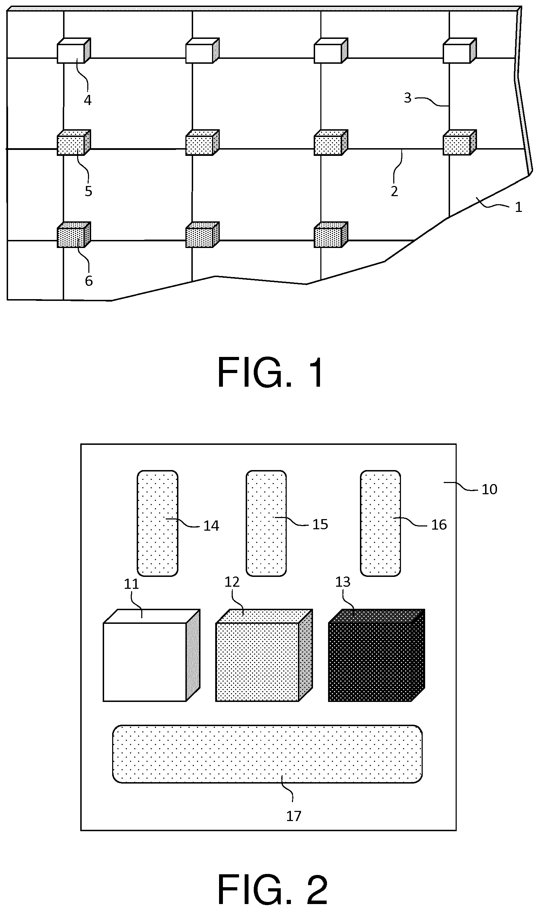

Un afficheur transparent comporte une matrice de pixels émissifs colorés adressés par un ensemble de lignes et de colonnes conductrices. Chaque intersection de lignes et de colonnes comporte un pixel et son électronique d'adressage comme on le voit sur la figure 1.

Pour que l'écran conserve une bonne transparence, il suffit que l'ensemble des lignes, des colonnes, des pixels et de l'électronique associée n'occupe qu'une faible partie de l'écran.

Les pixels émissifs peuvent être des diodes électroluminescentes ou « LED » qui présentent de nombreux avantages. On citera notamment une puissance émettrice importante, un faible encombrement et une fiabilité élevée.

Dans ce cas, l'électronique de commande ou d'adressage comporte plusieurs transistors réalisés en couches minces. L'un au moins connecté à une ligne et une colonne réalise la mémorisation de l'information vidéo. Un second transistor connecté à une alimentation et à la diode électroluminescente contrôle le courant dans celle-ci. Celui-ci peut être disposé sous la diode de façon à réduire la surface occupée par la matrice de diodes.

La façon la plus simple de réaliser cet écran transparent à diodes électroluminescentes est montrée sur la figure 1 qui représente une vue partielle d'un écran implanté sur un substrat transparent 1. Chaque intersection de lignes 2 et de colonnes 3 d'adressage comporte une diode électroluminescente unique. Pour réaliser un afficheur couleur, on utilise trois types de diodes différentes 4, 5 et 6 émettant respectivement dans le rouge, le bleu et le vert.

Ce type d'écran a deux inconvénients importants. Si l'on veut réaliser un écran dit « Full HD », cet écran doit comporter 1080 lignes et 1920 colonnes. Chaque pixel coloré comporte alors trois diodes électroluminescentes élémentaires. Ainsi, l'écran comporte plus de 6 millions de diodes électroluminescentes. Si la machine de report des diodes est capable de reporter 60 000 composants à l'heure, il faut donc plus de 100 heures de report pour réaliser l'afficheur transparent.

Par ailleurs, les composants à manipuler par la méthode dite « Pick and Place » sont de très petite taille. Typiquement, une diode électroluminescente a des dimensions voisines de 100 microns. Ce sont donc des composants difficiles à manipuler et à positionner avec précision sur de grandes surfaces. Par ailleurs, ils sont susceptibles de bouger pendant le processus de thermalisation nécessaire à la solidification du composé de collage qui assure également la conduction électrique.

US 2015/371585 A1 divulgue un affichage à diodes électroluminescentes inorganiques micro-assemblées.

US 2008/218465 A1 divulgue un dispositif d'affichage dans lequel deux lignes de porte contrôlent trois pixels : un pixel est connecté aux deux lignes et est programmé lorsque les deux lignes sont actives.

US 2012/223875 A1 divulgue un procédé de fabrication d'un micro-affichage à grande échelle de diodes électroluminescentes en couleur sur silicium, et plus particulièrement fabrication d'un micro-affichage à LED monté sur un panneau à matrice active utilisant la technologie "flip-chip".

US 2014/353694 A1 divulgue un dispositif d'affichage à LED utilisant des composants unitaires de report de type SMD, les composants unitaires de report étant disposés de manière à réduire le coût et la complexité d'interconnexion pour les affichages.

US 2006/001625 A1 et US 2009/283781 divulguent des composant unitaires de report comprenant chacun un triplet de LED RVB et quatre connecteurs.

US 2012/168789 A1 divulgue un dispositif d'affichage transparent à LED comprenant un substrat transparent.

L'afficheur transparent selon l'invention diminue de façon sensible les inconvénients précédents. En effet, les diodes électroluminescentes sont regroupées par triplet « RGB », acronyme signifiant « Red - Green - Blue », chaque triplet constituant un pixel coloré. Ainsi, on diminue le nombre de composants à reporter, on augmente leur taille et on diminue le nombre de lignes et de colonnes d'adressage. L'afficheur demande moins de temps de réalisation, il est plus facile à réaliser, plus fiable et plus transparent.

Plus précisément, l'invention a pour objet un afficheur selon la revendication 1.

Avantageusement, la surface d'implantation du composant électronique est d'environ 300 microns par 300 microns dans le cas d'un triplet de diodes.

L'invention concerne également un procédé de réalisation d'un afficheur selon la revendication 3.

Avantageusement, dans une variante de réalisation, l'étape de collage est réalisée au moyen d'un film de collage conducteur du type « Anisotropic Conductive Film », la colle étant anisotrope, composée d'un milieu isolant comportant des microbilles conductrices.

L'invention sera mieux comprise et d'autres avantages apparaîtront à la lecture de la description qui va suivre donnée à titre non limitatif et grâce aux figures annexées parmi lesquelles :
La figure 1 précédemment commentée représente un écran transparent selon l'art antérieur ;
La figure 2 représente un triplet de diodes électroluminescentes selon l'invention ;
La figure 3 représente deux triplets de diodes électroluminescentes selon un exemple illustratif non compris dans l'invention revendiquée
La figure 4 représente quatre triplets de diodes électroluminescentes selon un exemple illustratif non compris dans l'invention revendiquée;
La figure 5 représente l'implantation des composants à quatre triplets de diodes sur un écran transparent ;
La figure 6 représente le circuit électrique de commande d'une diode électroluminescente ;
La figure 7 représente une variante du circuit électrique de commande de la figure 6 ;
La figure 8 représente le circuit électrique de commande d'un triplet de diodes électroluminescentes selon l'invention ;
La figure 9 représente le circuit électrique de commande d'un composant comportant quatre triplets de diodes électroluminescentes selon un exemple illustratif non compris dans l'invention revendiquée;
La figure 10 représente une variante du circuit électrique de commande de la figure 9 ;
La figure 11 représente le montage des composants à diodes électroluminescentes selon l'invention sur leur substrat transparent ;
La figure 12 représente une variante du montage des composants de la figure 11.

La figure 2 représente un triplet de diodes électroluminescentes selon l'invention. Il se présente sous la forme d'un composant électronique 10. Ce composant comporte trois diodes électroluminescentes 11, 12 et 13 émettant respectivement dans le rouge, le vert et le bleu. Ces diodes électroluminescentes peuvent être, à titre d'exemple, émettre les différentes couleurs en natif ou émettre les différentes couleurs par conversion soit avec des phosphores soit avec des « quantum dots ». En particulier, la couleur bleue peut être obtenue en émission directe ou être le fruit d'une conversion par un phosphore approprié ou des quantum dots à partir d'un rayonnement ultraviolet d'émission.

Les trois diodes sont réalisées sur le même substrat. A titre d'exemples, ce substrat peut être du saphir, du carbure de silicium ou du silicium.

Sur la figure 2, à titre d'exemple non limitatif, ces diodes électroluminescentes sont alignées. Ce composant comporte également quatre contacts électriques 14, 15, 16 et 17. Chaque diode électroluminescente a un contact électrique de commande dédié, les trois diodes ayant un contact électrique d'alimentation commun 17. Ainsi, par rapport à trois diodes unitaires, le composant comporte deux contacts de moins. La taille de chaque diode est d'environ 80µm × 120µm. Les dimensions de chaque contact ou « bump » sont environ 30µm × 80µm. La taille du composant unitaire est d'environ 300µm × 300µm. Cette taille se rapproche des standards de l'industrie de report des composants électroniques et permet de diviser par trois l'opération de report tout en la facilitant.

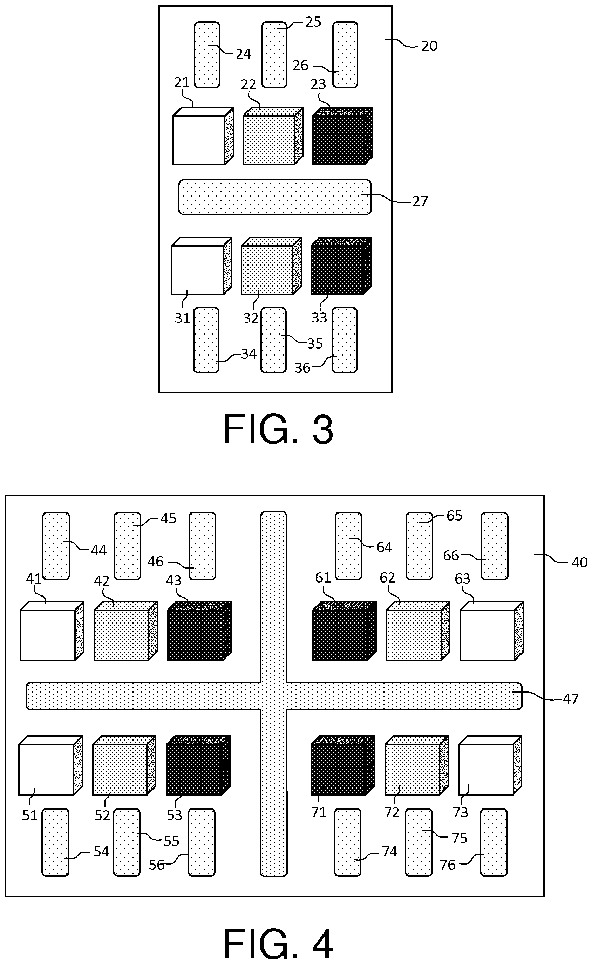

La figure 3 représente une première variante de ce composant. Le composant électronique 20 comporte deux triplets de trois diodes électroluminescentes 21, 22 et 23; et 31, 32 et 33 et sept contacts électriques 24-26, 34-36 et 27, chaque diode électroluminescente ayant un contact électrique de commande dédié, les six diodes ayant un contact électrique commun 27 aux six diodes électroluminescentes. L'implantation géométrique des diodes électroluminescentes et des contacts électriques de la figure 3 est donnée à titre d'exemple. Ainsi, par rapport à six diodes unitaires, le composant comporte cinq contacts de moins. La taille du composant unitaire est d'environ 600µm × 300µm. On divise une nouvelle fois par deux le temps de report précédent.

La figure 4 représente une seconde variante de ce composant. Le composant électronique 40 comporte quatre triplets de trois diodes électroluminescentes 41-43, 51-53, 61-63 et 71-73 et 13 contacts électriques 44-46, 54-56, 64-66, 74-76 et 47, chaque diode électroluminescente ayant un contact électrique de commande dédié, les douze diodes ayant un contact électrique commun 47 aux douze diodes électroluminescentes. L'implantation géométrique des diodes électroluminescentes et des contacts électriques de la figure 4 est donnée à titre d'exemple. La taille du composant unitaire est d'environ 600µm × 600µm. Ainsi, par rapport à douze diodes unitaires, le composant comporte onze contacts de moins. Ce type de composant permet de diviser par douze le temps de report d'un écran couleur. Pour un écran « full HD », il faut alors reporter 518 400 composants élémentaires, ce qui peut être réalisé en 8,64 heures sur une machine de report rapide à 60000 composants par heure.

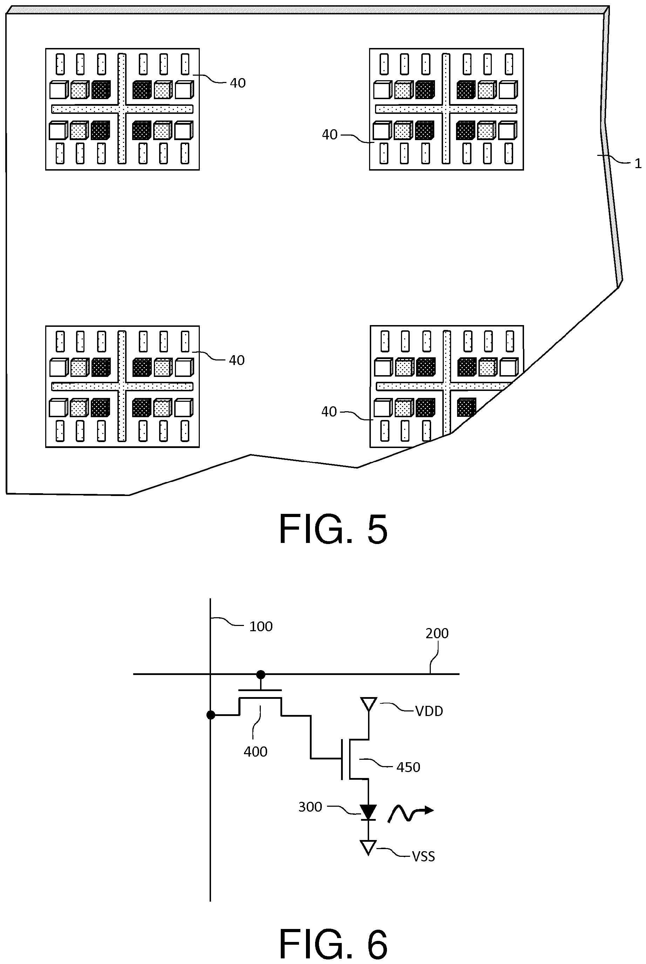

Comme on le voit sur la figure 5 qui représente une vue partielle d'un écran, ce type de composant 40 permet de réaliser des écrans de grande taille avec une surface de diodes électroluminescentes sur un substrat en saphir réduite typiquement de l'ordre de 10% de la surface du verre de la matrice active 1. Dans le cas de la figure 5, les composants sont implantés tous les millimètres.

La figure 6 représente l'électronique de commande d'une diode électroluminescente 300. Celle-ci est implantée sur la lame transparente au voisinage des intersections entre les différentes lignes 200 et colonnes 100.

Elle comporte deux plans d'alimentation électrique notés classiquement « VDD » et « VSS » sur la figure 6 et deux transistors de commande 400 et 450. Le premier transistor 400 est connecté à la colonne de commande 100 et à la ligne de commande 200. Il pilote le transistor 450 qui commande la diode électroluminescente 300.

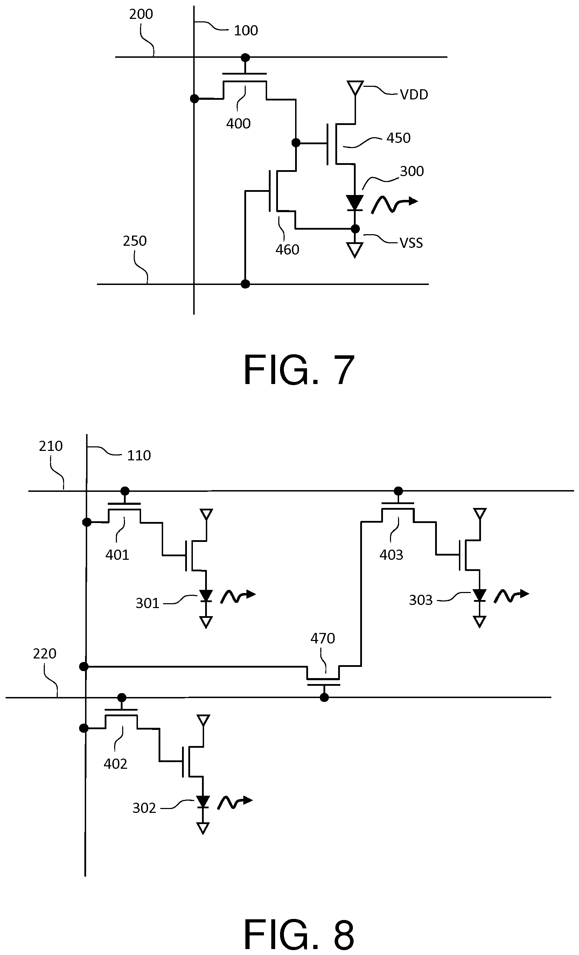

Le dispositif de commande de la LED peut être réalisé avec un plus grand nombre de transistors pour améliorer les performances de l'afficheur. On citera :
- L'ajout de transistors de compensation des variations des caractéristiques électriques entre les diodes ou entre les transistors pour compenser les tensions de seuil ;
- L'ajout d'un transistor 460 dit de RESET, tel que représenté sur la figure 7. On utilise les mêmes notations dans cette figure que dans la précédente. Ce transistor est connecté à une ligne dite de « reset » 250, au transistor 450 et au plan d'alimentation VSS. Il permet de diminuer le temps d'activation des diodes, de façon à autoriser une réduction de l'émission de lumière lorsque l'afficheur est utilisé dans un environnement sombre.

Pour commander un triplet de diodes électroluminescentes, on peut affecter une ligne et une colonne de commande à chaque diode électroluminescente, soit au total six lignes conductrices de commande. Cependant, dans le cas d'un triplet de diodes selon l'invention, la commande peut être réalisée au moyen d'une seule ligne et de trois colonnes de commande, soit au total seulement quatre lignes conductrices de commande.

On peut encore diminuer le nombre de lignes conductrices nécessaires pour le pilotage d'un triplet de diodes selon l'invention comme on le voit sur le schéma électrique de la figure 8. Dans ce cas, un triplet de LED RGB peut être commandé par uniquement deux lignes 210 et 220 et une seule colonne 110, soit trois lignes conductrices.

Le dispositif électronique est le suivant. La première diode 301 est commandée classiquement par une électronique à deux transistors telle que décrite en figure 6, le transistor 401 étant relié à la ligne 210 et à la colonne 110. De la même façon, la seconde diode 302 est commandée classiquement par une électronique à deux transistors, le transistor 402 étant relié à la ligne 220 et à la colonne 110. La troisième diode 303 comporte également une électronique de commande à deux transistors mais le transistor 403 est relié à un transistor 470 commandé par la colonne 110 et la ligne 220. Ainsi, au moyen des transistors 402 et 470, la diode est connectée à la colonne de commande 110 et aux deux lignes de commande 210 et 220.

Le fonctionnement du triplet est le suivant. La ligne 210 active la diode 301, puis la ligne 220 active la diode 302. Enfin, l'action simultanée des lignes 210 et 220 active la diode 303. La colonne 110 présente l'information correspondant à la diode 303 pendant l'activation simultanée des deux lignes 210 et 220 puis l'information correspondant à la diode 301 pendant l'activation uniquement de la première ligne 210 et l'information correspondant à la diode 302 pendant l'activation uniquement de la ligne 220.

La réduction du nombre de lignes et de colonnes permet de réduire la surface de métal de la matrice active et donc favorise la transparence de l'afficheur.

Les principes précédents peuvent être mis en œuvre pour alimenter un composant électronique comportant quatre triplets de trois diodes. Dans ce cas, le circuit d'alimentation comprend deux lignes et quatre colonnes.

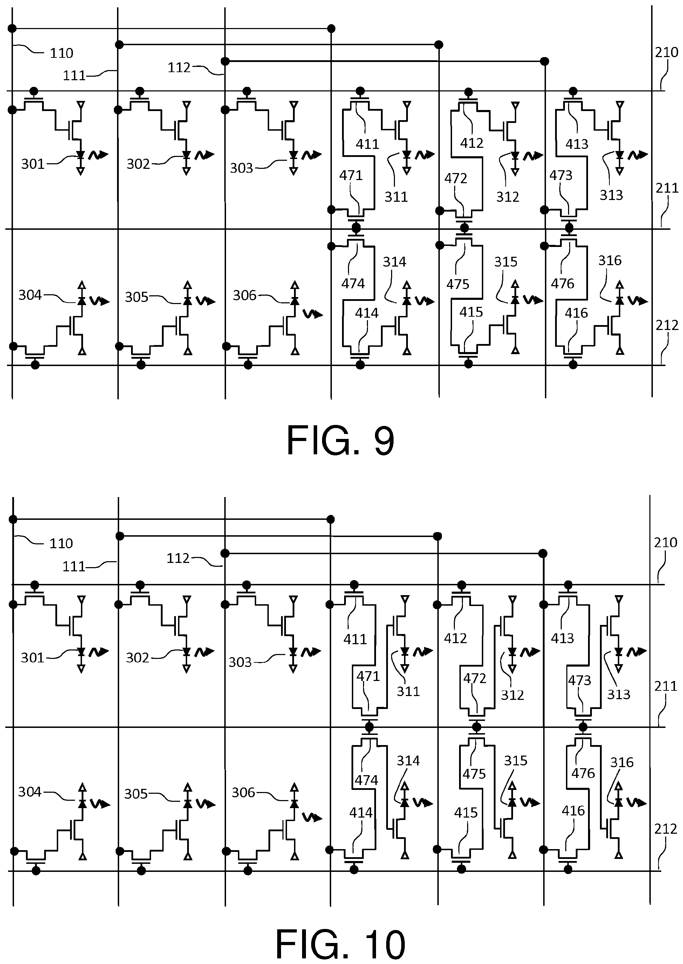

Dans une variante de réalisation, il est possible d'alimenter un composant comportant douze diodes au moyen de trois lignes et de trois colonnes de commande. Le schéma du circuit électronique de commande correspondant est représenté en figure 9. Il comporte trois lignes 210, 211 et 212 et trois colonnes 110, 111 et 112.

Un premier triplet de diodes 301, 302 et 303 est relié d'une part à la première colonne de commande 110, à la seconde colonne de commande 111 et à la troisième colonne de commande 112 et d'autre part à la première ligne de commande 210.

Le second triplet de diodes 304, 305 et 306 est relié d'une part à la première colonne de commande 110, à la seconde colonne de commande 111 et à la troisième colonne de commande 112 et d'autre part à la seconde ligne de commande 212.

Le troisième triplet de diodes 311, 312 et 313 est relié d'une part à la première colonne de commande 110, à la seconde colonne de commande 111 et à la troisième colonne de commande 112 et d'autre part à la première ligne de commande 210 et à la troisième ligne de commande 211 au moyen d'un premier triplet d'échantillonneurs bloqueurs 471, 472 et 473. Chaque échantillonneur bloqueur est relié à une colonne, à la ligne 211 et au transistor qui pilote la diode correspondante. Ainsi, l'échantillonneur bloqueur 471 est relié à la colonne 110, à la ligne 211 et au transistor 411 qui pilote la diode 311.

Le quatrième triplet de diodes 314, 315 et 316 est relié d'une part à la première colonne de commande 110, à la seconde colonne de commande 111 et à la troisième colonne de commande 112 et d'autre part à la seconde ligne de commande 212 et à la troisième ligne de commande 212 au moyen d'un second triplet d'échantillonneurs bloqueurs 474, 475 et 476.

Les diodes 311 à 316 comportant un échantillonneur bloqueur sont systématiquement activées avant les diodes 301 à 306. Les lignes 210 et 211 sont activées simultanément avant l'activation de la ligne 210 seule et, de même, les lignes 211 et 212 sont activées simultanément avant l'activation de la ligne 212 seule.

Dans une variante de réalisation représentée en figure 10 du circuit électronique d'adressage de la figure 9, les transistors échantillonneurs bloqueurs 471 à 476 sont raccordés différemment. Chaque échantillonneur bloqueur est relié à un premier transistor de commande, à la ligne 211 et au second transistor qui pilote la diode correspondante. Ainsi, l'échantillonneur bloqueur 471 est relié au transistor 411, à la ligne 211 et au second transistor qui pilote la diode 311.

Dans tous les cas de commande des diodes avec deux transistors en série dans les échantillonneurs bloqueurs, le transistor le plus proche électriquement de la colonne doit être bloqué en dernier de façon à réduire le couplage ligne-diode émettrice.

Les parties des électrodes du substrat transparent disposées sous les composants peuvent être réfléchissantes de façon à favoriser l'émission de la lumière émise par les diodes électroluminescentes vers l'utilisateur. Il est préférable que la surface de l'électronique de commande des composants selon l'invention soit totalement masquée par le composant lui-même de façon à optimiser la transmission de l'afficheur.

Le report des composants selon l'invention sur la lame transparente comportant les lignes et les colonnes de commande et l'électronique de commande associée peut être réalisé au moyen d'une colle conductrice.

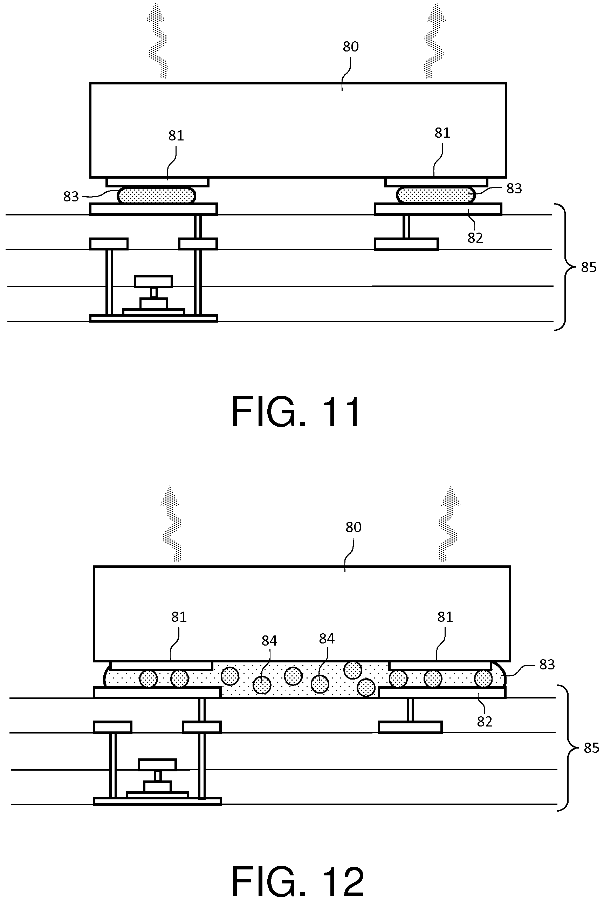

Dans un premier mode de réalisation représenté sur la figure 11, les contacts 81 du composant 80 sont fixés sur les contacts 82 de l'électronique de commande 85 au moyen de plots 83 de colle conductrice. L'électronique de commande est représentée de façon simplifiée sur cette figure et la suivante. Sur cette figure 11 et la suivante, les diodes électroluminescentes ne sont pas représentées. Cette colle conductrice est isotrope. Elle est du type pâte à braser ou son équivalent. A titre d'exemple, elle est disposée sur les contacts de la matrice active par sérigraphie puis polymérisée à chaud.

Dans un second mode de réalisation représenté sur la figure 12, les contacts 81 du composant 80 sont fixés sur les contacts 82 de l'électronique de commande 85 au moyen d'un plot unique 83 de colle conductrice. Cette colle conductrice est anisotrope. Elle contient un milieu isolant comportant des éléments conducteurs disjoints 84. Ces éléments peuvent être des microbilles revêtues d'or ou d'un autre métal. Comme précédemment, chaque plot peut être déposé par sérigraphie. On peut également utiliser une colle en ruban contenant les microbilles à revêtement métallique, le ruban étant du type « ACF », acronyme de « Anisotropic Conductive Film ». Cette colle est alors laminée en bande sur le verre. Ces différentes colles sont polymérisées à chaud ou sous ultraviolet et sous pression.

Ces méthodes de montage peuvent s'appliquer à des composants comportant un triplet de diodes électroluminescentes ou deux triplets ou quatre triplets. Par ailleurs, il est préférable que le matériau utilisé pour le collage soit opaque de façon à réduire la quantité de lumière qui se propage vers les transistors de commande dont le fonctionnement pourrait être perturbé par cette lumière.

## Revendications

1. Afficheur comportant une lame transparente (1) et une matrice de pixels composés de diodes électroluminescentes disposée sur ladite lame, **caractérisé en ce que** chaque pixel est un composant électronique (10) unitaire de report comportant uniquement un triplet de trois diodes électroluminescentes (11-13) émettant dans trois spectres différents et quatre contacts électriques (14-17), les trois diodes électroluminescentes étant réalisées sur un même substrat, chaque diode électroluminescente ayant un contact électrique (14-16) de commande dédié, les trois diodes ayant un contact électrique (17) commun auxdites trois diodes électroluminescentes, la surface occupée par la matrice de pixels étant de l'ordre de 10% de la surface de la lame transparente, ledit substrat étant distinct de la lame transparente, ledit substrat étant de saphir, de carbure de silicium ou du silicium.

2. Afficheur selon la revendication 1, **caractérisé en ce que** la surface d'implantation de chaque composant électronique (10) est d'environ 300 microns par 300 microns.

3. Procédé de réalisation d'un afficheur selon l'une des revendications précédentes, **caractérisé en ce qu'**il comporte une étape de collage des composants électroniques (10) sur des plots de collage (83), la colle étant conductrice, isotrope et du type pâte à braser.

4. Procédé de réalisation d'un afficheur selon l'une des revendications 1 à 2, **caractérisé en ce qu'**il comporte une étape de collage des composants électroniques (10) au moyen d'un film de collage (83) conducteur du type « Anisotropic Conductive Film », la colle étant anisotrope, composée d'un milieu isolant comportant des microbilles conductrices (84).

## Patentansprüche

1. Anzeigevorrichtung, welche ein transparentes Blatt (1) und eine Matrix aus Pixeln aufweist, welche aus Leuchtdioden zusammengesetzt sind, welche auf dem Blatt angeordnet ist, **dadurch gekennzeichnet, dass** jeder Pixel ein elektronisches Übertragungs-Einzelbauteil (10) ist, welches nur ein Tripel aus drei Leuchtdioden (11-13), welche in drei unterschiedlichen Spektren emittieren, und vier elektrische Kontakte (14-17) aufweist, wobei die drei Leuchtdioden auf einem gleichen Substrat hergestellt sind, wobei jede Leuchtdiode einen spezifischen elektrischen Steuerungskontakt (14-16) aufweist, wobei die drei Dioden einen den drei Leuchtdioden gemeinsamen elektrischen Kontakt (17) aufweisen, wobei die durch die Pixelmatrix belegte Fläche ungefähr 10 % der Fläche des transparenten Blattes ausmacht, wobei das Substrat sich von dem transparenten Blatt unterscheidet, wobei das Substrat aus Saphir, aus Siliziumkarbid oder aus Silizium besteht.

2. Anzeigevorrichtung nach Anspruch 1, **dadurch gekennzeichnet, dass** die Implantationsfläche eines jeden elektronischen Bauteils (10) ungefähr 300 Mikrometer mal 300 Mikrometer beträgt.

3. Herstellungsverfahren einer Anzeigevorrichtung nach einem der vorhergehenden Ansprüche, **dadurch gekennzeichnet, dass** es einen Schritt des Klebens der elektronischen Bauteile (10) auf Klebehöcker (83) aufweist, wobei der Klebstoff leitfähig, isotrop und lötpastenartig ist.

4. Herstellungsverfahren einer Anzeigevorrichtung nach einem der Ansprüche 1 bis 2, **dadurch gekennzeichnet, dass** es einen Schritt des Klebens der elektronischen Bauteile (10) mithilfe eines leitfähigen Klebefilms (83) vom Typ "Anisotroper Leitfähiger Film" aufweist, wobei der Klebstoff anisotrop ist und aus einem isolierenden Medium, welches leitfähige Mikrokügelchen (84) aufweist, zusammengesetzt ist.

## Claims

1. Display having a transparent plate (1) and a matrix of pixels composed of light-emitting diodes arranged on said plate, **characterised in that** each pixel is a unitary carryover electronic component (10) having only a triplet of three light-emitting diodes (11-13) emitting in three different spectra and four electrical contacts (14-17), the three light-emitting diodes being produced on one and the same substrate, each light-emitting diode having a dedicated electrical control contact (14-16), the three diodes having an electrical contact (17) that is common to said three light-emitting diodes, the area occupied by the matrix of pixels being in the order of 10% of the surface of the transparent plate, said substrate being distinct from the transparent plate, said substrate being made of sapphire, silicon carbide or silicon.

2. Display according to claim 1, **characterised in that** the placement surface of each electronic component (10) is about 300 microns by 300 microns.

3. Process for producing a display according to one of the preceding claims, **characterised in that** it has a step of bonding the electronic components to bonding pads (83), the adhesive being conductive, isotropic and of solder paste-type.

4. Process for producing a display according to one of claims 1 to 2, **characterised in that** it has a step of bonding the electronic components (10) by means of an conductive bonding film (83) of "Anisotropic Conductive Film" type, the adhesive being anisotropic and made of an insulating medium having conductive microbeads (84).
